# EUROPEAN PATENT SPECIFICATION

(11) **EP 4 017 231 B1**
(45) Date of publication and mention of the grant of the patent: **13.08.2025**
(21) Application number: 20861726.6
(22) Date of filing: 26.08.2020
(51) Int. Cl.: H05K 7/20

(54) **COMPOUND TEETH RADIATOR AND COMMUNICATION BASE STATION**
VERBUNDZAHNSTRAHLER UND KOMMUNIKATIONSBASISSTATION
RADIATEUR À DENTS COMPOSÉES ET STATION DE BASE DE COMMUNICATION

(30) Priority: 04.09.2019 CN 201921462483 U
(43) Date of publication of application: 22.06.2022
(73) Proprietor: ZTE Corporation, Shenzhen, Guangdong 518057 (CN)
(72) Inventor: ZHOU, Ailan, Shenzhen, Guangdong 518057 (CN); TIAN, Zhiji, Shenzhen, Guangdong 518057 (CN); ZHANG, Jinchuan, Shenzhen, Guangdong 518057 (CN)
(74) Representative: WBH Wachenhausen Patentanwälte PartG mbB
(86) International application number: PCT/CN2020/111531
(87) International publication number: WO 2021/043047

(56) References cited:
- WO-A1-2008/129134
- WO-A1-2008/129134
- CN-A- 103 187 893
- CN-A- 103 187 893
- CN-A- 103 957 682
- CN-A- 105 072 873
- CN-A- 108 901 188
- CN-U- 209 710 561
- CN-U- 210 725 817
- DE-U1- 202013 007 768
- DE-U1- 202018 101 375
- JP-A- 2001 337 612
- JP-A- 2003 298 268
- JP-A- 2003 298 268
- JP-A- H06 163 771
- US-A1- 2001 003 304

## Description

### TECHNICAL FIELD

Embodiments of the present disclosure relate to the field of heat radiating technologies, and in particular, to a combined fin radiator and a communication base station.

### BACKGROUND

Wireless communication has evolved from 2G to 3G and 4G, and currently to 5G which is about to be well-known to everyone. With the development of communication technologies, the faster transmission speed and the greater power output lead to the increase of heat consumption for an entire system from 300 W to currently 1500 W, the increase of heat consumption per unit volume from 20 W/L to 30 to 40 W/L, and the increase of chip power consumption from a dozen watts to 20 to 45 W, for an outdoor communication base station. High reliability of the communication base station in outdoor application environment relies on heat dissipation, in most cases, on natural heat radiating, as other heat-dissipating methods, including air cooling and liquid cooling which are used in industries such as IT and big data industries, are difficult to be used. Therefore, the heat radiating capability of the radiator is critical for the outdoor communication base station.

For a conventional radiator used in the communication base station, most heat radiating fins included in the radiator are of a single vertical straight fin structure, its air inlet and outlet channels are single, and thus the heat radiating capability is poor. Alternatively, the heat radiating fins may be of a single V-shaped inclined fin structure, and an inclined air-out manner is used. However, when there is wind outdoors, such a structure is easily affected by the headwind to the natural convection, i.e., hot air formed by natural convection cannot flow out. Consequently, the temperature of the entire system of the communication base station rises, the heat radiating performance is impaired, and the reliability of long-term outdoor use is poor.

To address the foregoing problem, the heat radiating effect may be improved by increasing the fin height of the heat radiating fins or enlarging the overall volume of the radiator. However, the increased fin height of the heat radiating fin or the enlarged overall volume of the radiator may cause increase in the cost and the weight accordingly. In addition, limited by the die-casting technology, there is a limitation on the highest fin height, therefore, the heat radiating problem cannot be effectively solved.

In JP 2001337612 A, to enable to lower a surface temperature of a device by realizing the stable high thermal radiation efficiency over the inside/outside of the device with low cost and light weight, the device is constituted by possessing thermal conduction members as a means to conduct the heat of heat generation parts inside a housing, which houses an image forming panel and a driving circuit substrate and is comprised of housing parts to the housing, being mounted wall-hanging fixing units as a means to rule the distance to a wall behind the housing and thermal insulating materials as a thermal insulating means between the back cover of the housing and bezels and the thermal conduction members possess the elasticity.

In DE 202013007768 U1, a circuit with at least one cooling rib array arranged on the chassis is used for passively cooling parts. The circuit in the shell adopts natural convection mode, which is characterized in that the cooling rib array has at least two ribs and/or rib sections in different directions.

In JPH 06163771A, a structure in which air-current control plates are arranged on both sides of a multichip module. The air-current control plates are arranged on side faces of the multichip module in positions parallel to the flow direction of a cooling air current. Since the air-current control plates are bent at an angle to become wider than the width of the multichip module on the upstream side of the air-current control plates, the cooling air current flows to cooling fins in a concentrated manner.

In US 2001/003304 A1, a heat exchanger and a method of manufacturing the heat exchanger is disclosed for dissipating heat from a heat generating component. The heat exchanger comprises a thermally conductive base in thermal communication with the component, a plurality of thermally conductive plate fins affixed to the base wherein the plate fins define a fin field and channels, and fluid control for controlling the fluid flow within the fin field. The individual fins of the heat exchanger comprise textured regions positioned about a side surface of the fins and extending into an adjacent channel. The positioning of the textured regions function to minimize formation of high pressure within the fin field by disturbing the fluid flow passing along the fins. Alternatively or in conjunction with the above-outlined embodiments, the heat exchanger may comprise a fluid control feature for substantially preventing premature egress of fluid from a top region of the fin field caused by the high pressure region within the fin field.

In CN 108901188A, a radiation cooling device of an outdoor communication radio frequency base station is disclosed. The radiation cooling device comprises a mounting box body that comprises two mounting panels which are arranged in parallel, two mounting side plates and two sealing plates; a plurality of mounting holes are formed in the mounting side plates. A plurality of heat dissipation blades are arranged on each mounting panel in parallel and at equal interval. A radiation refrigeration layer and a protection layer are arranged on the surface of each heat dissipation blade in sequence. Each radiation refrigeration layer comprises macromolecular resin, micron spheres and a coating auxiliary agent. The micron spheres contain one or more of ATO, ITO, Fe₃O₄, TiO₂, SiO₂, SiC, SiS₂ and ZnO.

### SUMMARY

In view of this, according to embodiments of the present disclosure, a combined fin radiator and a communication base station are set out in the appended set of claims.

### BRIEF DESCRIPTION OF DRAWINGS

FIG. 1 is a schematic diagram of a combined fin radiator according to Embodiment I of the present disclosure;
FIG. 2 is a front view of the combined fin radiator according to Embodiment I of the present disclosure;
FIG. 3 is a schematic diagram of a combined fin radiator according to Embodiment II of the present disclosure;
FIG. 4 is a sectional view of the combined fin radiator according to Embodiment II of the present disclosure;
FIG. 5 is a schematic diagram showing derivation fins are fastened as one through a framework according to Embodiment II of the present disclosure;
FIG. 6 is a schematic diagram of a combined fin radiator according to Embodiment III of the present disclosure;
FIG. 7 is a front view of the combined fin radiator according to Embodiment III of the present disclosure;
FIG. 8 is a schematic diagram of a combined fin radiator according to Embodiment IV of the present disclosure;
FIG. 9 is a schematic diagram of a combined fin radiator according to Embodiment V of the present disclosure;
FIG. 10 is a front view of the combined fin radiator according to Embodiment V of the present disclosure;
FIG. 11 is a schematic diagram of a combined fin radiator according to Embodiment VI of the present disclosure;
FIG. 12 is a front view of the combined fin radiator according to Embodiment VI of the present disclosure;
FIG. 13 is a schematic diagram of a combined fin radiator according to Embodiment VII of the present disclosure;
FIG. 14 is a front view of a combined fin radiator according to Embodiment VIII of the present disclosure;
FIG. 15 is a front view of a combined fin radiator according to Embodiment IX of the present disclosure; and
FIG. 16 is a schematic diagram of a communication base station according to Embodiment X of the present disclosure.

### Reference numbers:

1 Base board; 21 First straight fin; 22 First air duct; 31 Second air duct; 32 Inclined fin; 33 Third air duct; 4 Edge fin; 41 Fourth air duct; 5 Derivation fin; 6 Cover plate; 71 Second straight fin; 72 Fifth air duct; 8 First derivation fin; 9 First cover plate; 10 Second cover plate; 20 Third cover plate; and 30 Fourth cover plate.

### DETAILED DESCRIPTION

The present disclosure is further described in detail below with reference to the accompanying drawings and embodiments. It is to be understood that specific embodiments described herein are merely intended to explain the present disclosure, but are not intended to limit the present disclosure. In addition, it should be further noted that, for ease of description, only part but not all of the structures related to the present disclosure are shown in the accompanying drawings.

In the descriptions of the present disclosure, unless otherwise expressly specified and limited, terms such as "connected", "connection", and "fastened" shall be understood in a broad sense. For example, "connection" may be a fixed connection, a detachable connection, or an integral connection; may be a mechanical connection or an electrical connection; may be a direct connection or an indirect connection through an intermediate; or may be a communication within two elements or an interaction relationship between two elements. A person of ordinary skill in the art may understand specific meanings of the foregoing terms in the present disclosure according to specific circumstances.

In the present disclosure, unless otherwise expressly specified and limited, that a first feature is "above" or "below" a second feature may include that the first feature is directly in contact with the second feature, or may include that the first feature is in contact with the second feature through another feature between the first feature and the second feature instead of being directly in contact with the second feature. In addition, that the first feature is "above", "over", and "on" the second feature includes that the first feature is directly above and obliquely above the second feature, or merely indicates that the first feature is horizontally higher than the second feature. That the first feature is "below", "under", and "underneath" the second feature includes that the first feature is directly below and obliquely below the second feature, or merely indicates that the first feature is horizontally lower than the second feature.

In the descriptions of embodiments, orientation or location relationships of terms such as "upper", "lower", and "right" are orientation or location relationships shown based on the accompanying drawings, and are merely used for ease of description and simplifying operation, rather than indicating or implying that the apparatus or the element must have a specific orientation or be constructed and operated in a specific orientation. Therefore, this cannot be understood as a limitation on the present disclosure. In addition, terms such as "first" and "second" are merely used to distinguish in terms of description and have no special meanings.

### Embodiment I

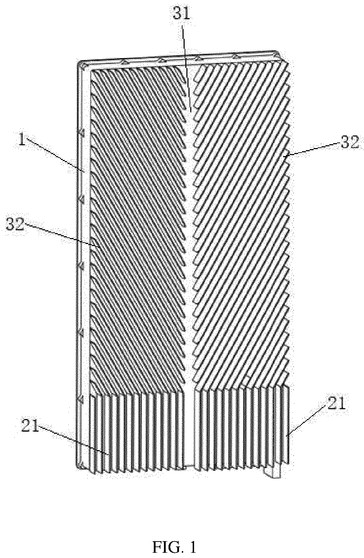

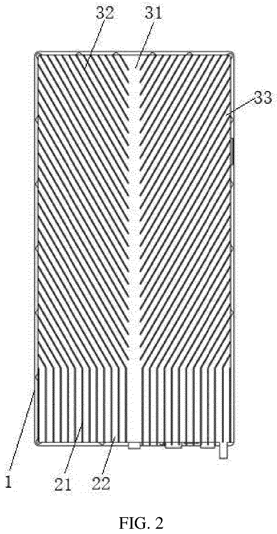

This embodiment provides a combined fin radiator, which may be used in a communication device such as a communication base station, to perform natural heat radiating on the communication device such as the communication base station. In this embodiment, the communication base station is used as an example. As shown in FIG. 1 and FIG. 2, the combined fin radiator in this embodiment includes a base board 1, a first heat radiating assembly, and a second heat radiating assembly.

The base board 1 is configured to dispose the entire combined fin radiator on the communication base station, and the base board 1 is generally vertically arranged on the communication base station.

The first heat radiating assembly is provided on a front surface of the base board 1, and in some examples, the first heat radiating assembly is provided on a lower part of the base board 1 in a height direction. The first heat radiating assembly includes a plurality of first straight fins 21 provided at equal intervals. The first straight fins 21 are provided in the height direction of the base board 1, and each of a plurality of first air duct 22 is formed between adjacent two of the first straight fins 21, so that cold air can flow into the first air ducts 22 from the bottom of the base board 1, to cool a heat source component, of the communication base station, located in an area of the first air duct 22.

In this embodiment, a thermal bottleneck area is formed based on a location of the heat source component of the communication base station. When the first straight fins 21 are provided, the first straight fins 21 extend upwards from the bottom of the base board 1 to an area above the thermal bottleneck area, where the area is at least 100 mm above the thermal bottleneck area. In this way, the first heat radiating assembly has improved heat radiating effect in the thermal bottleneck area.

The second heat radiating assembly is also provided on the front surface of the base board 1 and butted against the first heat radiating assembly, and in some cases, the second heat radiating assembly is provided on an upper part of the base board 1 in the height direction. The second heat radiating assembly includes two symmetrically arranged inclined fin groups, and a second air duct 31 is formed between the two inclined fin groups. The second air duct 31 extends upwards from the first straight fins 21 to the top of the base board 1, and the second air duct 31 can be communicated with one or more intermediate first air ducts 22 (which may be one first air duct 22, or may be several intermediate and adjacent first air ducts 22). In this embodiment, the width of the second air duct 31 is exactly the same as a sum of widths of some intermediate first air ducts 22.

Each of the inclined fin groups includes a plurality of inclined fins 32, and the inclined fins 32 are arranged upwards at equal intervals and in parallel in the height direction of the base board 1. A plurality of third air ducts 33 are provided, each of the third air ducts 33 is formed between adjacent two of the inclined fins 32 and has an air outlet arranged away from a symmetrical center of the inclined fin groups. In other words, the air outlets of the third air ducts 33 are located on the left side and the right side of the base board 1.

Part of the third air ducts 33 are communicated with the rest of the first air ducts 22 that are not communicated with the second air duct 31. Specifically, the third air ducts 33 located on the lower part are communicated with the first air duct 22. In this case, it can be learned that, a distance between adjacent two of the inclined fins 32 and a distance between adjacent two of the first straight fins 21 are the same, so that the width of the third air ducts 33 is consistent with the width of the first air ducts 22. In this way, when the second heat radiating assembly is butted against the first heat radiating assembly, the third air ducts 33 located on the lower part can be butted against the first air ducts 22, so as to implement a moderate transition of air between the first air ducts 22 and the third air ducts 33.

In this embodiment, through the second air duct 31 and the third air ducts 33, air in the first air ducts 22 can enter the second air duct 31 and the third air ducts 33, to cool the heat source component of the communication base station in a process of flowing in the second air duct 31 and the third air ducts 33. In addition, hot air obtained through heat transfer flows out of the air outlets of the third air ducts 33. In other words, heat energy is taken away from the left side and the right side of the radiator, but does not flow out of the top of the radiator, and only minority of the hot air flows out of the top of the radiator through the second air duct 31. In this way, heating of lower hot air on the top of the radiator can be relieved, in other words, the heat radiating effect of the top of the radiator is improved.

In some examples, the inclined fin 32 has a certain included angle with the height direction of the base board 1, and an angle of the included angle may be 30° to 45°, so that an air flow velocity in the formed second air duct 31 is moderate, sufficient heat transfer can be performed, and the air flow velocity can be prevented from being excessively slow.

Integral die casting molding is adopted to make the base board 1, the first heat radiating assembly, and the second heat radiating assembly in the combined fin radiator in this embodiment. In addition, the first air ducts 22 formed between the first straight fins 21 of the first heat radiating assembly are communicated with the third air ducts 33 formed between the inclined fins 32 of the second heat radiating assembly, so that an air inlet channel and an air outlet channel of a traditional radiator using natural convection heat radiating are adjusted, the convective heat transfer of the cold air on the first straight fins 21 and the inclined fins 32 is enhanced, and the heat accumulation of heat source components located on an upper part and a lower part of the radiator is reduced. In addition, the temperature of a component located on the upper part of the radiator or the communication device can be reduced by 5 to 8 degrees, and the temperature of a component located on the lower part of the radiator or the communication device can be reduced by 4 degrees, without increasing an overall volume and a height of a heat radiating fin, thereby improving heat radiating performance by 20% to 30%.

In addition, in this embodiment, the first heat radiating assembly is provided on the lower part. Compared with a structure in which all heat radiating fins of the radiator are inclined fins, this embodiment can improve a natural convection effect and a soaking capability of the lower part of the radiator, and improve reliability of the radiator being used outdoors for a long time. In addition, the second heat radiating assembly is provided on the upper part, so that a problem that the temperature of the top of the radiator is excessively high and heat radiating temperatures are unbalanced can be avoided, where the problem is caused by the hot air flowing out of the top of radiator when all the heat radiating fins of the radiator are straight fins. In this way, a heat radiating capability of the radiator is improved.

### Embodiment II

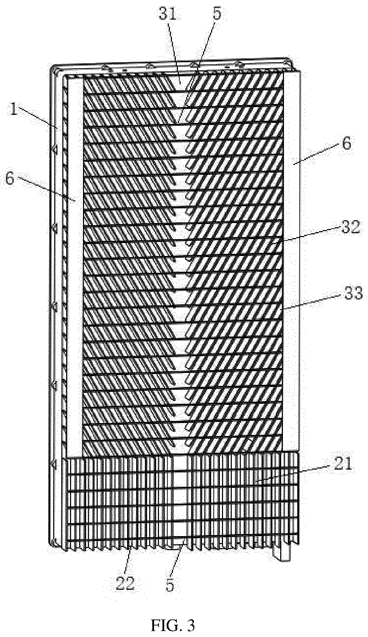

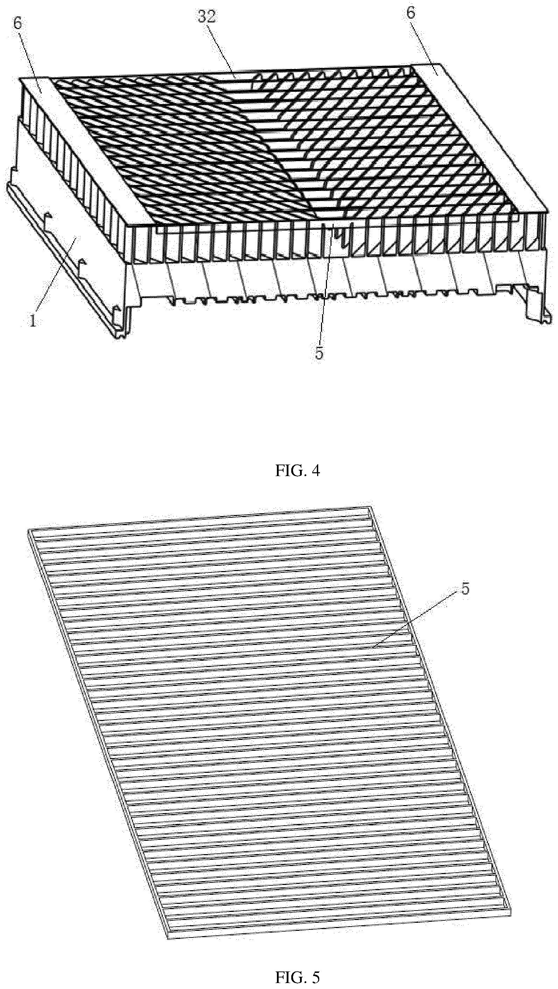

As shown in FIGS. 3 and 4, a combined fin radiator provided in this embodiment includes a base board 1, a first heat radiating assembly, a second heat radiating assembly, a plurality of derivation fins 5, and a cover plate 6. Structures of the base board 1, the first heat radiating assembly, and the second heat radiating assembly are the same as those in Embodiment I, and details are not described again. In this embodiment, only the structures of the derivation fins 5 and the cover plate 6 are described.

In this embodiment, the plurality of derivation fins 5 are provided at intervals, and the derivation fins 5 extend from one side to the other side in a width direction of the base board 1. In some examples, the plurality of derivation fins 5 are provided at equal intervals. In addition, part of the derivation fins 5 are interleaved with the first straight fins 21 of the first heat radiating assembly to form air inlet holes, and the rest of the derivation fins 5 are interleaved with inclined fins 32 of the second heat radiating assembly to form air inlet holes. Outside air can be directed into the first air ducts 22 and the second air ducts 31 through the air inlet holes, to implement a manner of air inlet from a plurality of orientations rather than only from the bottom of the radiator.

In some examples, the derivation fins 5 may be provided on end surfaces of the first straight fins 21 and the inclined fins 32, and fastened to the end surfaces of the first straight fins 21 and the inclined fins 32 in a manner such as welding, screw fastening, or bonding. Alternatively, slots may be provided on the top of the first straight fins 21 and the inclined fins 32, and the derivation fins 5 are embedded into the slots of the first straight fins 21 and the inclined fins 32 by using interference fit (see the structure shown in FIG. 4). In addition, the derivation fins 5 may be mounted separately, or the plurality of derivation fins 5 may be processed and molded integrally, and the derivation fins 5 are mounted on the first straight fins 21 and the inclined fins 32. As shown in FIG. 5, the plurality of derivation fins 5 are integrally made, that is, stamped from a metal plate. Subsequently, the integrated derivation fins 5 are fastened to upper parts of the first straight fins 21 and the inclined fins 32, and the plurality of derivation fins 5 are fastened to the first straight fins 21 and the inclined fins 32 in the foregoing fastening manner.

In this embodiment, the width and the thickness of the derivation fins 5 and the shape of the air inlet holes may be set according to needs. Through the derivation fins 5, cold air can flow not only from the bottom of the radiator, but also from a front porous structure of the radiator, so as to adjust a location in which the cold air enters and a location from which the hot air exists of the radiator, and adjust the internal temperature distribution.

Further, in this embodiment, the cover plate 6 may further be provided. The cover plate 6 is arranged at the air outlets of the third air ducts 33. In other words, the cover plate 6 extends at least from an air outlet of a third air duct 33 at the bottom to an air outlet of a third air duct 33 at the top. End portions of the derivation fins 5 on the inclined fins 32 are abutted against one side of the cover plate 6. By means of the cover plate 6, hot air flowing out of the third air ducts 33 can quickly flow out along the cover plate 6, in other words, cold air entering through the air inlet hole can quickly flow into the third air ducts 33. In addition, in this embodiment, the cover plate 6 cooperates with the derivation fins 5 to increase a chimney effect, so that more cold air enters through the air opening formed by the derivation fins 5, thereby improving a velocity and an air volume of the cold air flowing into the third air ducts 33. In some examples, the thickness of the cover plate 6 is about 1 mm, and the width is 1/3 of the length of the inclined fin 32.

In this embodiment, the cover plate 6 and the derivation fins 5 may be processed and molded separately, or may be processed and molded integrally, and then mounted together on the end surfaces of the first straight fins 21 and the inclined fins 32.

### Embodiment III

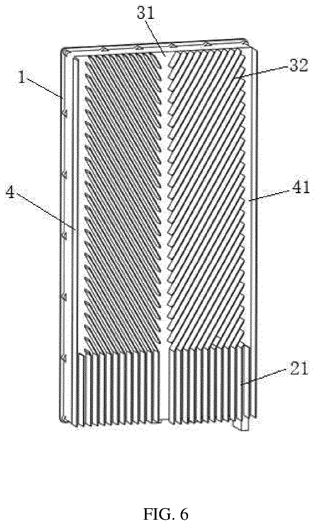

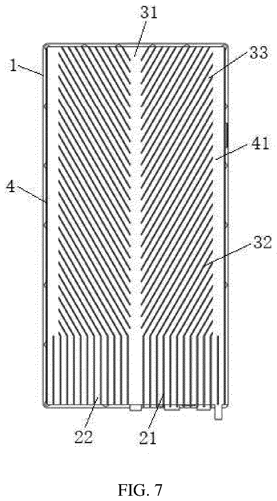

As shown in FIGS. 6 and 7, a combined fin radiator provided in this embodiment includes a base board 1, a first heat radiating assembly, a second heat radiating assembly, and edge fins 4 provided on the base board 1. Structures of the base board 1, the first heat radiating assembly, and the second heat radiating assembly are the same as those in Embodiment I. The edge fins 4 in this embodiment may be in a plate-like structure, vertically provided on a front surface of the base board 1, and located on two sides of the second heat radiating assembly. A fourth air duct 41 can be formed between each edge fin 4 and the air outlets of the adjacent third air ducts 33. The fourth air duct 41 extends at least from an air outlet of a third air duct 33 at the bottom to an air outlet of a third air duct 33 at the top. Through the fourth air duct 41, hot air after heat transfer can uniformly flow into the fourth air duct 41 through the third air ducts 33 (except the hot air flowing into a second air duct 31), and finally flow out of the top of the fourth air duct 41, thereby forming a chimney effect and avoiding impact of headwinds on inclined fins 32 when there are winds outdoors. In this way, a problem that hot air in the third air duct 33 formed by natural convection between the inclined fins 32 cannot flow out, causing deterioration in heat radiating is prevented.

In some examples, in this embodiment, first air ducts 22 may be further added at both side edges of the base board 1, so that the first air ducts 22 are communicated with bottom ports of the fourth air ducts 41. In this case, air flowing in through the first air ducts 22 can directly enters the fourth air ducts 41 through the bottom ports of the fourth air ducts 41, and flows out of the top of the fourth air ducts 41.

In this embodiment, through the fourth air ducts 41, the hot air can uniformly flow out of air outlets of the fourth air ducts 41 and the second air duct 31, that is, flow out of the top of the radiator. This can weaken heat accumulation impact of the hot air in the first air ducts 22 and the third air ducts 33 on a component located on the top of a communication base station corresponding to the radiator. In addition, as the outdoor wind basically comes all the directions, around the communication base station, the hot air flowing out through the top of the radiator allow the hot air flowing out of the third air ducts 33 not to be blocked by the outdoor winds, and thus heat radiating is not deteriorated, in a breeze. This solves a problem that system reliability of a traditional inclined fin radiator is poor when there is a breeze outdoors.

### Embodiment IV

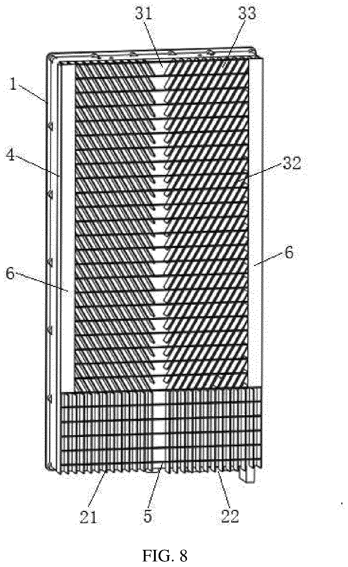

This embodiment provides a combined fin radiator. On the basis of Embodiment II, the structure in Embodiment III is added in the combined fin radiator. Specifically, as shown in FIG. 8, the combined fin radiator in this embodiment includes a base board 1, a first heat radiating assembly, a second heat radiating assembly, derivation fins 5, a cover plate 6, and edge fins 4. Structures and arrangements of the foregoing components are the same as those in Embodiment II and Embodiment III. In this embodiment, mainly the cover plate 6 is engaged with the edge fins 4, allowing the fourth air ducts to be closed channels. With the combined fin radiator of the embodiment, quick discharge of the hot air can be enhanced, and the outside air can quickly flow in through the air inlet holes and from the bottom of the radiator. In addition, the chimney effect formed by the fourth air ducts can be further improved, so as to avoid the headwind impact on inclined fins 32 when there is wind outdoors. In this way, a problem that hot air in a third air duct 33 formed between the inclined fins 32 cannot flow out because of natural convection can be prevented.

### Embodiment V

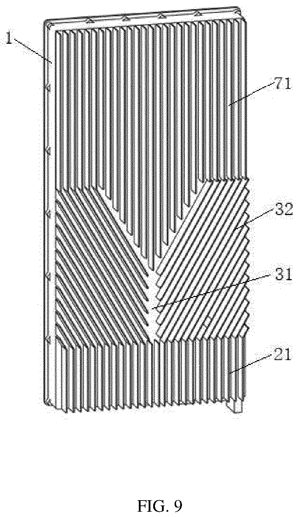

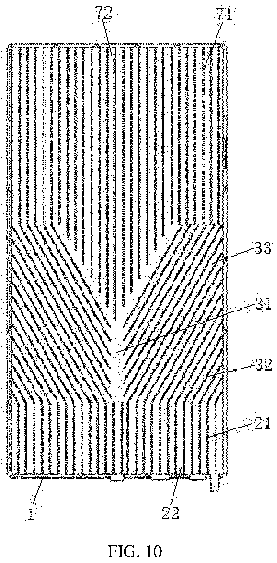

This embodiment provides a combined fin radiator. As shown in FIGS. 9 and 10, the combined fin radiator includes a base board 1, a first heat radiating assembly, a second heat radiating assembly, and a third heat radiating assembly. Structures of the base board 1, the first heat radiating assembly, and the second heat radiating assembly are the same as those in Embodiment I, and details are not described again. In this embodiment only the structure of the third heat radiating assembly is described.

In this embodiment, the third heat radiating assembly is provided on the top of the base board 1 and butted against the second heat radiating assembly. In some examples, the third heat radiating assembly includes a plurality of second straight fins 71 arranged at equal intervals. The second straight fins 71 are arranged in parallel, and a distance between adjacent two of the second straight fins 71 is the same as it between adjacent two of the inclined fins 32. Each of a plurality of fifth air ducts 72 is formed between adjacent two of the second straight fins 71, and part of the fifth air ducts 72 are communicated with a second air duct 31. The third heat radiating assembly is provided above the second heat radiating assembly, causing a blank area formed between two inclined fin groups of the second heat radiating assembly. Therefore, the length of the second straight fins 71 forming the part of the fifth air ducts 72 communicating with the second air duct 31 is extended based on a size of the blank area, so that the part of the fifth air ducts 72 can be communicated with the second air duct 31. The rest of the fifth air ducts 72 that are not communicated with the second air duct 31 respectively are communicated with third air ducts 33 butted.

According to the foregoing structures of this embodiment, after the cold air flowing in through the first air ducts 22 flows into the second air duct 31 and third air ducts 33 respectively, the cold air flows into the corresponding fifth air ducts 72, and finally flows out of the fifth air ducts 72. In this way, the radiator can have further improved heat radiating capability, the heat accumulation impact on components at various locations of the communication base station can be reduced, and most of the heat air flows out of the radiator form the top of the radiator, whereby the problem that the hot air of the inclined fins 32 cannot flow out and consequently the heat radiating is deteriorated due to the headwind impact on the inclined fins 32 when there is a breeze outdoors, is alleviated.

### Embodiment VI

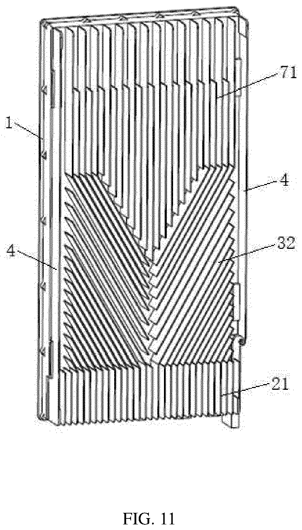

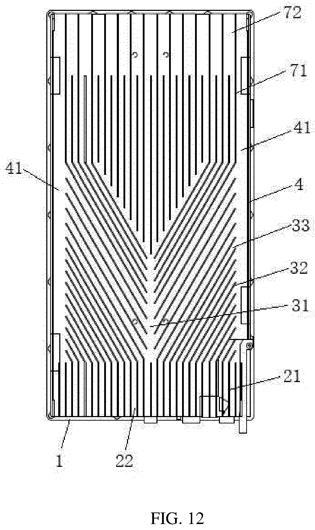

On the basis of Embodiment V, in this embodiment, edge fins 4 are added. As shown in FIG. 11 and FIG. 12, the combined fin radiator includes the base board 1, the first heat radiating assembly, the second heat radiating assembly, the third heat radiating assembly, and the edge fins 4. Structures of the base board 1, the first heat radiating assembly, the second heat radiating assembly, and the third heat radiating assembly are the same as those in Embodiment V. The edge fins 4 in this embodiment may be in a plate-like structure, vertically arranged on a front surface of the base board 1, and located on both sides of the first heat radiating assembly, the second heat radiating assembly, and the third heat radiating assembly. A fourth air duct 41 can be formed between an edge fin 4 and an adjacent first straight fin 21, an air outlet of the third air duct 33, and the second straight fin 71. Through the fourth air duct 41, hot air uniformly flows out of the top of the fourth air duct 41, to form a chimney effect, so as to avoid headwind impact on the inclined fins 32 when there is wind outdoors. In this way, a problem that hot air in the third air ducts 33 formed between by inclined fins 32 cannot flow out because of natural convection, is solved.

In this embodiment, through the fourth air ducts 41, the hot air can uniformly flow out through air outlets of the fourth air ducts 41 and the air outlets of the fifth air ducts 72 communicating with the second air duct 31, that is, flow out of the radiator from the top. This can weaken the heat accumulation impact of the hot air in the first air ducts 22 and the third air ducts 33 on a component located on the top of the communication base station corresponding to the fifth air duct 72. In addition, as the outdoor winds basically come from all directions, around the communication base station, the hot air flowing out through the top of the radiator allows the hot air flowing out of the third air duct 33 not to be blocked by the outdoor winds, and thus the heat radiating is not deteriorated in a breeze. This solves a problem that the system reliability of a traditional inclined fin radiator is poor when there is a breeze outdoors.

### Embodiment VII

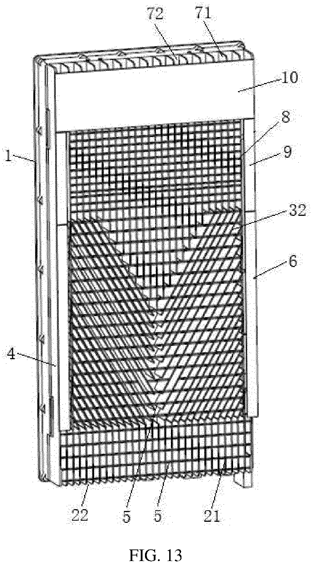

On the basis of Embodiment VI, in this embodiment, derivation fins 5, a cover plate 6, first derivation fins 8, a first cover plate 9, and a second cover plate 10 are added. Specifically, as shown in FIG. 13, the combined fin radiator includes the base board 1, the first heat radiating assembly, the second heat radiating assembly, the third heat radiating assembly, the edge fins 4, the derivation fins 5, the cover plate 6, the first derivation fins 8, the first cover plate 9, and the second cover plate 10. Structures of the base board 1, the first heat radiating assembly, the second heat radiating assembly, the third heat radiating assembly, and the edge fins 4 are the same as those in Embodiment VI. Structures and arrangements of the derivation fins 5 and the cover plate 6 are the same as those in Embodiment II. The foregoing components are not described again. Here only the structures of the first derivation fins 8, the first cover plate 9, and the second cover plate 10 are described for this embodiment.

In this embodiment, a plurality of first derivation fins 8 are provided at intervals, and the first derivation fins 8 extend from one side to the other side in a width direction of the base board 1. In some examples, the plurality of first derivation fins 8 are provided at equal intervals. In addition, the first derivation fins 8 are interleaved with the second straight fins 71 of the third heat radiating assembly to form air inlet holes. Outside air can flows into the first air duct 22 and the second air duct 31 through the air inlet holes formed by the derivation fins 5, the first straight fins 21 and the inclined fins 32, and as well flows into the fifth air ducts 72 through the air inlets formed by the first derivation fins 8 and the second straight fins 71, allowing the air to flow in from a plurality of orientations

In some examples, the first derivation fins 8 may be arranged on end surfaces of the second straight fins 71, and fastened to the end surfaces of the second straight fins 71 in a manner such as welding, screw fastening, or bonding. Alternatively, slots may be provided on the top of the second straight fins 71, and the first derivation fins 8 are embedded into the second straight fins 71 by an interference fit. In addition, the first derivation fins 8 may be separately mounted, or a plurality of first derivation fins 8 may be processed and molded integrally, and the first derivation fins 8 are mounted on the second straight fins 71.

In this embodiment, the width and the thickness of the first derivation fin 8 and the shape of the air inlet holes may be set according to needs. Through the first derivation fins 8, cold air can flow in not only from the bottom of the radiator, but also from a front porous structure of the radiator, so as to adjust a location in which the cold air flows in and a location from which the hot air flows out of the radiator, and consequently to adjust the internal temperature distribution.

Further, in this embodiment, the first cover plate 9 may be provided. The first cover plate 9 covers non-air-outlet areas of the fifth air ducts 72 located on both sides, in the width direction, of the base board 1, and the first cover plate 9 is abutted against one end of the cover plate 6.

The first cover plate 9 is engaged with the edge fins 4, and cooperates the engagement of the cover plate 6 and the edge fins 4, to allow the fourth air ducts 41 and an edge fifth air duct s72 to jointly form closed channels. By using the first cover plate 9 and the first derivation fins 8, the hot air flowing out of the fourth air ducts 41 can quickly flow out of the fifth air ducts 72 along the first cover plate 9, so that the cold air flowing in through the air inlet holes can quickly flow into the fifth air ducts 72. In addition, in this embodiment, the first cover plate 9 and the cover plate 6 cooperate with the derivation fins 5, to improve a velocity and an air volume of the cold air flowing into the third air duct 33. In some examples, the thickness of the first cover plate 9 is about 1 mm, and the width is 1/3 of the length of the inclined fin 32.

Further, the second cover plate 10 is provided in this embodiment, where the second cover plate 10 extends from one side to the other side in the width direction of the base board 1, and covers air outlet areas of all the fifth air ducts 72. The first cover plate 9 and the edge fins 4 are separately connected to the second cover plate 10. By using the second cover plate 10, hot air in the fifth air duct 72 can quickly flow out of the top of the radiator. In addition, in this embodiment, the second cover plate 10 cooperates with the first derivation fins 8, to improve the velocity and the air volume of the cold air flowing into the fifth air duct 72.

In this embodiment, the first cover plate 9, the second cover plate 10, and the first derivation fins 8 may be processed and molded separately, or may be processed and molded integrally.

### Embodiment VIII

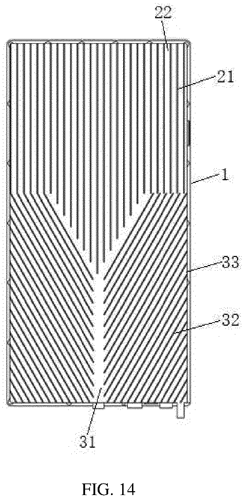

This embodiment provides a combined fin radiator. As shown in FIG. 14, the combined fin radiator in this embodiment includes a base board 1, a first heat radiating assembly, and a second heat radiating assembly. Structures of the base board 1, the first heat radiating assembly, and the second heat radiating assembly are the same as those in Embodiment I.

In this embodiment, the second heat radiating assembly is arranged below the first heat radiating assembly. In other words, in this embodiment, the first air ducts 22 formed by the first straight fins 21 are arranged on an upper part of the base board 1, and the second air duct 31 formed by the two inclined fin groups and the third air ducts 33 formed by the inclined fins 32 are arranged on a lower part of the base board 1.

### Embodiment IX

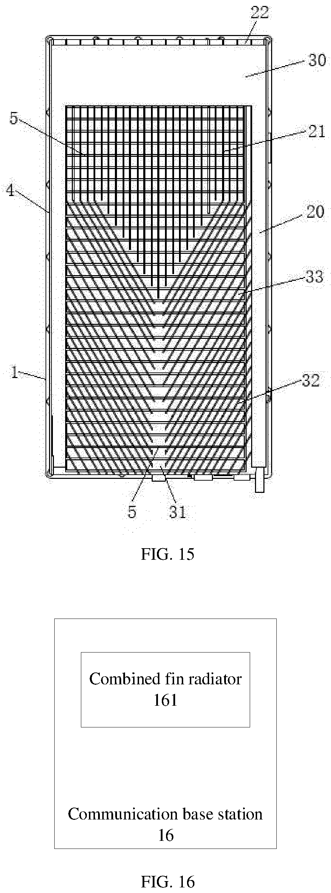

This embodiment provides a combined fin radiator. As shown in FIG. 15, the combined fin radiator in this embodiment includes edge fins 4, derivation fins 4, a third cover plate 20, and a fourth cover plate 30 that are added on the basis of Embodiment VIII. Structures of the edge fins 4 and the derivation fins 5 are the same as those in Embodiment IV, and structures of the third cover plate 20 and the fourth cover plate 30 are the same as those of the first cover plate 9 and the second cover plate 10 in Embodiment VII. Therefore, here the structures of the foregoing structures are described again.

In addition, in this embodiment, the third cover plate 20 is arranged at the air outlets of the third air ducts 33 and in the non-air-outlet areas of first air ducts 22 located on both sides, in a width direction, of the base board 1. In other words, in this embodiment, the third cover plate 20 extends from the bottom of the base board 1 to the top of the base board 1, to reach the non-air-outlet areas of the first air ducts 22. End portions of the derivation fins 5 are abutted against one side of the third cover plate 20. The fourth cover plate 30 is arranged to cover the top of the first heat radiating assembly. Specifically, the fourth cover plate 30 extends from one side to the other side in the width direction of the base board 1, and covers the air outlet areas of all the first air ducts 22. In addition, the edge fins 4 are connected to the third cover plate 20 and the fourth cover plate 30 to form closed fourth air ducts.

### Embodiment X

This embodiment provides a communication base station, including one of the combined fin radiators of Embodiment I to Embodiment IX, so that the temperature of a component located on an upper part of the communication device can be reduced by 5 to 8 degrees, and the temperature of a component located on a lower part of the communication device can be reduced by 4 degrees, thereby improving the heat radiating effect of the components of the communication base station. As shown in FIG. 16, the communication base station 61 in this embodiment includes a combined fin radiator 161.

According to an embodiment of the present disclosure provided is a combined fin radiator, which can provide improved heat radiating performance at least to some extend without increasing the overall volume and height of the heat radiating fin.

According to another embodiment of the present disclosure provided is a communication base station, by means of the combined fin radiator, the heat energy of an entire system can be effectively reduced at least to some extent, whereby improved use reliability is provided.

According to the embodiments of the present disclosure, the first air ducts formed by the first straight fins of the first heat radiating assembly are communicated with the third air ducts formed by the inclined fins of the second heat radiating assembly, such that the air inlet channels and outlet channels of a traditional radiator using natural convection heat radiating are optimized, the convective heat transfer of cold air on the first straight fins and the inclined fins is enhanced, and the heat accumulation of heat source components located on an upper part and a lower part of the radiator is reduced. In addition, the temperature of a component located on the upper part of the radiator or the communication device can be reduced by 5 to 8 degrees and the temperature of a component located on the lower part of the radiator or the communication device can be reduced by 4 degrees, without increasing the overall volume and height of the heat radiating fin, thereby improving heat radiating performance by 20% to 30%.

According to the embodiments of the present disclosure, the edge fins are provided, allowing the vertical fourth air ducts to be formed at the edges of the first heat radiating assembly and the second heat radiating assembly. The hot air uniformly flows out of the top of the fourth air duct, forming a chimney effect, so as to avoid the headwind impact on the inclined fins when there is wind outdoors. In this way, a problem that the hot air in the third air ducts formed by the inclined fins cannot flow out because of natural convection, is prevented.

## Claims

1. A combined fin radiator, comprising:
a base board (1) provided with an edge fin (4);
a first heat radiating assembly, arranged on the base board (1), and comprising a plurality of first straight fins (21) and a plurality of first air ducts (22) each formed between adjacent two of the first straight fins (21);
a second heat radiating assembly, arranged on the base board (1) and butted against the first heat radiating assembly, the second heat radiating assembly comprising two symmetrically arranged inclined fin groups and a second air duct (31) formed between the two inclined fin groups, wherein each of the inclined fin groups comprises a plurality of inclined fins (32) and a plurality of third air ducts (33) each formed between adjacent two of the inclined fins (32) such that an air outlet of each of the plurality of first air ducts (22) is connected with that of a corresponding one of the plurality of third air ducts (33), and the third air ducts (33) have air outlets arranged away from a symmetrical center of the inclined fin groups;
a fourth air duct (41) formed between the edge fin (4) and the air outlets of the third air ducts (33); and
a thermal bottleneck area formed based on a location of a heat source component so that the first straight fins (21) extend upwards from a bottom of the base board (1) to an area above the thermal bottleneck area which is above the thermal bottleneck area;
wherein
part of the first air ducts (22) are communicated with the second air duct (31), and the rest of the first air ducts (22) are communicated with the third air ducts (33) butted, respectively.

2. The combined fin radiator of claim 1, wherein the first air ducts (22) and fourth air ducts (41), arranged on both sides of the first heat radiating assembly, are communicated with each other.

3. The combined fin radiator of claim 1, further comprising a plurality of derivation fins (5) arranged at intervals, wherein the derivation fins (5) extend from one side to the other side in a width direction of the base board (1), part of the derivation fins (5) are interleaved with the first straight fins (21), and the rest of the derivation fins (5) are interleaved with the inclined fins (32), respectively to form air inlet holes.

4. The combined fin radiator of claim 3, further comprising a cover plate (6) arranged at the air outlets of the third air ducts (33).

5. The combined fin radiator of claim 1, wherein end portions of the derivation fins (5) are abutted against one side of the cover plate (6).

6. The combined fin radiator of one of claims 1 to 5, wherein the first heat radiating assembly is arranged below the second heat radiating assembly in a height direction of the base board (1).

7. The combined fin radiator of one of claims 1 to 5, further comprising a third heat radiating assembly, the third heat radiating assembly comprising a plurality of second straight fins (71) and a plurality of fifth air ducts (72) each formed between adjacent two of the second straight fins (71), wherein part of the fifth air ducts (72) are communicated with the second air duct (31), and the rest of the fifth air ducts (72) are communicated with the third air ducts (33) butted, respectively.

8. The combined fin radiator of claim 7, further comprising a plurality of first derivation fins (8), wherein the first derivation fins (8) extend from one side to the other side in the width direction of the base board (1), and the first derivation fins (8) are interleaved with the second straight fins (71) to form air inlet holes.

9. The combined fin radiator of claim 8, further comprising a first cover plate (9) covering non-air-outlet areas of the fifth air ducts (72) located on both sides in the width direction of the base board (1); and/or
the combined fin radiator further comprising a second cover plate (10), extending from one side to the other side in the width direction of the base board (1), and covering air-outlet areas of all the fifth air ducts (72).

10. The combined fin radiator of one of claims 1 to 3, wherein the second heat radiating assembly is arranged below the first heat radiating assembly in the height direction of the base board (1).

11. The combined fin radiator of claim 10, further comprising a third cover plate (20) arranged at the air outlets of the third air ducts (33) and in non-air-outlet areas of the first air ducts (22) located on both sides in the width direction of the base board (1), and end portions of the derivation fins (5) are abutted against one side of the third cover plate (20); and/or
the combined fin radiator further comprising a fourth cover plate (30) extending from one side to the other side in the width direction of the base board (1), and covering air-outlet areas of all the first air ducts (22).

12. A communication base station, comprising the combined fin radiator of one of claims 1 to 11.

## Patentansprüche

1. Kombinierter Rippenstrahler, umfassend:
eine Grundplatte (1), die mit einer Randrippe (4) versehen ist;
eine erste Wärmeabstrahlungsanordnung, die auf der Grundplatte (1) angeordnet ist und eine Vielzahl von ersten geraden Rippen (21) und eine Vielzahl von ersten Luftkanälen (22) umfasst, die jeweils zwischen benachbarten zwei der ersten geraden Rippen (21) ausgebildet sind;
eine zweite Wärmeabstrahlungsanordnung, die auf der Grundplatte (1) angeordnet ist und an der ersten Wärmeabstrahlungsanordnung anliegt, wobei die zweite Wärmeabstrahlungsanordnung zwei symmetrisch angeordnete geneigte Rippengruppen und einen zweiten Luftkanal (31) umfasst, der zwischen den zwei geneigten Rippengruppen ausgebildet ist, wobei jede der geneigten Rippengruppen eine Vielzahl von geneigten Rippen (32) und eine Vielzahl von dritten Luftkanälen (33) umfasst, die jeweils zwischen benachbarten zwei der geneigten Rippen (32) ausgebildet sind, so dass ein Luftauslass jedes der Vielzahl von ersten Luftkanälen (22) mit dem eines entsprechenden der Vielzahl von dritten Luftkanälen (33) verbunden ist, und die dritten Luftkanäle (33) Luftauslässe aufweisen, die von einer symmetrischen Mitte der geneigten Rippengruppen entfernt angeordnet sind;
einen vierten Luftkanal (41), der zwischen der Randrippe (4) und den Luftauslässen der dritten Luftkanäle (33) ausgebildet ist; und
einen thermischen Engpassbereich, der basierend auf einer Position einer Wärmequellenkomponente ausgebildet ist, so dass sich die ersten geraden Rippen (21) von einem Ende der Grundplatte (1) nach oben zu einem Bereich über dem thermischen Engpassbereich erstrecken, der sich über dem thermischen Engpassbereich befindet;
wobei
Teil der ersten Luftkanäle (22) mit dem zweiten Luftkanal (31) in Verbindung steht und der Rest der ersten Luftkanäle (22) mit den jeweils anliegenden dritten Luftkanälen (33) in Verbindung steht.

2. Kombinierter Rippenstrahler nach Anspruch 1, wobei die ersten Luftkanäle (22) und die vierten Luftkanäle (41), die auf beiden Seiten der ersten Wärmeabstrahlungsanordnung angeordnet sind, miteinander in Verbindung stehen.

3. Kombinierter Rippenstrahler nach Anspruch 1, ferner umfassend eine Vielzahl von Ableitungsrippen (5), die in Intervallen angeordnet sind, wobei sich die Ableitungsrippen (5) von einer Seite zur anderen Seite in einer Breitenrichtung der Grundplatte (1) erstrecken, Teil der Ableitungsrippen (5) mit den ersten geraden Rippen (21) verschachtelt ist und der Rest der Ableitungsrippen (5) jeweils mit den geneigten Rippen (32) verschachtelt ist, um Lufteinlasslöcher zu bilden.

4. Kombinierter Rippenstrahler nach Anspruch 3, ferner umfassend eine Abdeckplatte (6), die an den Luftauslässen der dritten Luftkanäle (33) angeordnet ist.

5. Kombinierter Rippenstrahler nach Anspruch 1, wobei Endabschnitte der Ableitungsrippen (5) an einer Seite der Abdeckplatte (6) anliegen.

6. Kombinierter Rippenstrahler nach einem der Ansprüche 1 bis 5, wobei die erste Wärmeabstrahlungsanordnung in einer Höhenrichtung der Grundplatte (1) unter der zweiten Wärmeabstrahlungsanordnung angeordnet ist.

7. Kombinierter Rippenstrahler nach einem der Ansprüche 1 bis 5, ferner umfassend eine dritte Wärmeabstrahlungsanordnung, wobei die dritte Wärmeabstrahlungsanordnung eine Vielzahl von zweiten geraden Rippen (71) und eine Vielzahl von fünften Luftkanälen (72) umfasst, die jeweils zwischen benachbarten zwei der zweiten geraden Rippen (71) ausgebildet sind, wobei Teil der fünften Luftkanäle (72) mit dem zweiten Luftkanal (31) in Verbindung steht und der Rest der fünften Luftkanäle (72) mit den jeweils anliegenden dritten Luftkanälen (33) in Verbindung steht.

8. Kombinierter Rippenstrahler nach Anspruch 7, ferner umfassend eine Vielzahl von ersten Ableitungsrippen (8), wobei sich die ersten Ableitungsrippen (8) von einer Seite zur anderen Seite in der Breitenrichtung der Grundplatte (1) erstrecken und die ersten Ableitungsrippen (8) mit den zweiten geraden Rippen (71) verschachtelt sind, um Lufteinlasslöcher zu bilden.

9. Kombinierter Rippenstrahler nach Anspruch 8, ferner umfassend eine erste Abdeckplatte (9), die Nicht-Luftauslassbereiche der fünften Luftkanäle (72) abdeckt, die sich auf beiden Seiten in der Breitenrichtung der Grundplatte (1) befinden; und/oder
wobei der kombinierte Rippenstrahler ferner eine zweite Abdeckplatte (10) umfasst, die sich von einer Seite zur anderen Seite in der Breitenrichtung der Grundplatte (1) erstreckt und Luftauslassbereiche aller fünften Luftkanäle (72) abdeckt.

10. Kombinierter Rippenstrahler nach einem der Ansprüche 1 bis 3, wobei die zweite Wärmeabstrahlungsanordnung in der Höhenrichtung der Grundplatte (1) unter der ersten Wärmeabstrahlungsanordnung angeordnet ist.

11. Kombinierter Rippenstrahler nach Anspruch 10, ferner umfassend eine dritte Abdeckplatte (20), die an den Luftauslässen der dritten Luftkanäle (33) und in Nicht-Luftauslassbereichen der ersten Luftkanäle (22) angeordnet ist, die sich auf beiden Seiten in der Breitenrichtung der Grundplatte (1) befinden, und Endabschnitte der Ableitungsrippen (5) an einer Seite der dritten Abdeckplatte (20) anliegen; und/oder
wobei der kombinierte Rippenstrahler ferner eine vierte Abdeckplatte (30) umfasst, die sich von einer Seite zur anderen Seite in der Breitenrichtung der Grundplatte (1) erstreckt und Luftauslassbereiche aller ersten Luftkanäle (22) abdeckt.

12. Kommunikationsbasisstation, umfassend den kombinierten Rippenstrahler nach einem der Ansprüche 1 bis 11.

## Revendications

1. Radiateur à ailettes combinées, comprenant :
une plaque de base (1) munie d'une ailette de bord (4) ; un premier ensemble de rayonnement de chaleur, agencé sur la plaque de base (1), et comprenant une pluralité de premières ailettes droites (21) et une pluralité de premiers conduits d'air (22) chacun formés entre deux ailettes adjacentes parmi les premières ailettes droites (21) ;
un deuxième ensemble de rayonnement de chaleur, agencé sur la plaque de base (1) et en butée contre le premier ensemble de rayonnement de chaleur, le deuxième ensemble de rayonnement de chaleur comprenant deux groupes d'ailettes inclinées agencées symétriquement et un deuxième conduit d'air (31) formé entre les deux groupes d'ailettes inclinées, chacun des groupes d'ailettes inclinées comprenant une pluralité d'ailettes inclinées (32) et une pluralité de troisièmes conduits d'air (33) chacun formés entre deux ailettes adjacentes parmi les ailettes inclinées (32) de telle sorte qu'une sortie d'air de chacun de la pluralité de premiers conduits d'air (22) soit relié à un conduit correspondant de la pluralité de troisièmes conduits d'air (33), et les troisièmes conduits d'air (33) ont des sorties d'air agencées à l'écart d'un centre symétrique des groupes d'ailettes inclinées ;
un quatrième conduit d'air (41) formé entre l'ailette de bord (4) et les sorties d'air des troisièmes conduits d'air (33 ); et
une zone de goulot d'étranglement thermique formée sur la base d'un emplacement d'un composant de source de chaleur de sorte que les premières ailettes droites (21) s'étendent vers le haut à partir d'un dessous de la plaque de base (1) jusqu'à une zone au-dessus de la zone de goulot d'étranglement thermique qui est au-dessus de la zone de goulot d'étranglement thermique ;
dans lequel
une partie des premiers conduits d'air (22) est en communication avec le deuxième conduit d'air (31), et le reste des premiers conduits d'air (22) est en communication avec les troisièmes conduits d'air (33) en butée, respectivement.

2. Radiateur à ailettes combinées selon la revendication 1, dans lequel les premiers conduits d'air (22) et les quatrièmes conduits d'air (41), agencés des deux côtés du premier ensemble de rayonnement de chaleur, sont en communication les uns avec les autres.

3. Radiateur à ailettes combiné selon la revendication 1, comprenant en outre une pluralité d'ailettes de dérivation (5) agencées à intervalles, les ailettes de dérivation (5) s'étendant d'un côté à l'autre côté dans une direction de la largeur de la plaque de base (1), une partie des ailettes de dérivation (5) étant entrelacée avec les premières ailettes droites (21), et le reste des ailettes de dérivation (5) étant entrelacé avec les ailettes inclinées (32), respectivement pour former des trous d'entrée d'air.

4. Radiateur à ailettes combinées selon la revendication 3, comprenant en outre une plaque de couverture (6) agencée au niveau des sorties d'air des troisièmes conduits d'air (33).

5. Radiateur à ailettes combinées selon la revendication 1, dans lequel des portions d'extrémité des ailettes de dérivation (5) sont en butée contre un côté de la plaque de couverture (6).

6. Radiateur à ailettes combinées selon l'une des revendications 1 à 5, dans lequel le premier ensemble de rayonnement de chaleur est agencé au-dessous du deuxième ensemble de rayonnement de chaleur dans une direction de hauteur de la plaque de base (1).

7. Radiateur à ailettes combinées selon l'une des revendications 1 à 5, comprenant en outre un troisième ensemble de rayonnement de chaleur, le troisième ensemble de rayonnement de chaleur comprenant une pluralité de deuxièmes ailettes droites (71) et une pluralité de cinquièmes conduits d'air (72) chacun formés entre deux des deuxièmes ailettes droites (71) adjacentes, une partie des cinquièmes conduits d'air (72) étant en communication avec le deuxième conduit d'air (31), et le reste des cinquièmes conduits d'air (72) étant en communication avec les troisièmes conduits d'air (33) en butée, respectivement.

8. Radiateur à ailettes combinées selon la revendication 7, comprenant en outre une pluralité de premières ailettes de dérivation (8), les premières ailettes de dérivation (8) s'étendant d'un côté à l'autre côté dans la direction de la largeur de la plaque de base (1), et les premières ailettes de dérivation (8) étant entrelacées avec les deuxièmes ailettes droites (71) pour former des trous d'entrée d'air.

9. Radiateur à ailettes combinées selon la revendication 8, comprenant en outre une première plaque de couverture (9) couvrant des zones de non sortie d'air des cinquièmes conduits d'air (72) situés des deux côtés dans la direction de la largeur de la plaque de base (1) ; et/ou
le radiateur à ailettes combinées comprenant en outre une deuxième plaque de couverture (10), s'étendant d'un côté à l'autre côté dans la direction de la largeur de la plaque de base (1), et couvrant des zones de sortie d'air de tous les cinquièmes conduits d'air (72).

10. Radiateur à ailettes combinées selon l'une des revendications 1 à 3, dans lequel le deuxième ensemble de rayonnement de chaleur est agencé au-dessous du premier ensemble de rayonnement de chaleur dans la direction de hauteur de la plaque de base (1).

11. Radiateur à ailettes combinées selon la revendication 10, comprenant en outre une troisième plaque de couverture (20) agencée au niveau des sorties d'air des troisièmes conduits d'air (33) et dans des zones de non sortie d'air des premiers conduits d'air (22) situés des deux côtés dans la direction de la largeur de la plaque de base (1), et des portions d'extrémité des ailettes de dérivation (5) sont en butée contre un côté de la troisième plaque de couverture (20) ; et/ou
le radiateur à ailettes combinées comprenant en outre une quatrième plaque de couverture (30), s'étendant d'un côté à l'autre côté dans la direction de la largeur de la plaque de base (1), et couvrant des zones de sortie d'air de tous les premiers conduits d'air (22).

12. Station de base de communication, comprenant le radiateur à ailettes combinées selon l'une des revendications 1 à 11.
